# EUROPÄISCHE PATENTSCHRIFT

(11) **EP 1 053 663 B1**
(45) Veröffentlichungstag und Bekanntmachung des Hinweises auf die Patenterteilung: **26.09.2001**
(21) Anmeldenummer: 99906163.3
(22) Anmeldetag: 19.01.1999
(51) Int. Cl.: H05K 7/20, H02B 1/56

(54) **SCHALTSCHRANK MIT EINRICHTUNGEN ZUM KÜHLEN DER INNENRAUM-WARMLUFT**
SWITCH CUPBOARD WITH DEVICES FOR COOLING THE HOT AIR INSIDE
ARMOIRE DE DISTRIBUTION MUNIE DE DISPOSITIFS POUR REFROIDIR L'AIR CHAUD PRESENT A L'INTERIEUR

(30) Priorität: 07.02.1998 DE 19804904
(43) Veröffentlichungstag der Anmeldung: 22.11.2000
(73) Patentinhaber: Rittal-Werk Rudolf Loh GmbH & Co. KG, 35745 Herborn (DE)
(72) Erfinder: NICOLAI, Walter, D-35418 Buseck (DE); PAWLOWSKI, Adam, D-35713 Eschenburg (DE)
(74) Vertreter: Fleck, Hermann-Josef, Dr.-Ing.
(86) Internationale Anmeldenummer: EP9900311
(87) Internationale Veröffentlichungsnummer: WO9940767

(56) Entgegenhaltungen:
- DE-U- 9 303 275
- DE-U- 29 518 201

## Beschreibung

Die Erfindung betrifft einen Schaltschrank mit Einrichtungen zum Kühlen der im Innenraum desselben auftretenden Warmluft, siehe z.B. DE-U-29 518 201.

Es sind Kühlgeräte bekannt, die auf die Oberseite des Schaltschrankes aufbaubar sind, die Warmluft aus dem Schaltschrank-Innenraum ansaugen und nach der Kühlung wieder dem Schaltschrank-Innenraum zuführen.

Es sind auch als Wandelemente ausgebildete Wärmetauscher bekannt, die dieselbe Funktion übernehmen.

Diese bekannten Einrichtungen haben den Nachteil, daß sie nicht an verschiedene Verhältnisse im Schaltschrank-Innenraum angepaßt werden können.

So tritt immer wieder der Wunsch auf, die Warmluft an ganz bestimmten Stellen des Innenraumes gezielt abzusaugen oder die wieder eingeführte Kaltluft an beliebigen Stellen des Innenraumes montierten Komponenten direkt zuzuführen.

Es ist Aufgabe der Erfindung, einen Schaltschrank mit Einrichtungen zum Kühlen der im Innenraum desselben auftretenden Warmluft so auszubilden, daß der Luftkreislauf im Innenraum leicht an unterschiedliche Gegebenheiten angepaßt werden kann.

Diese Aufgabe wird nach der Erfindung dadurch gelöst, daß mindestens eine Vertikalseite mit einem doppelwandigen Wandelement abgeschlossen ist, dessen äußeres und inneres Wandblatt einen großflächigen Luftkanal bilden und daß das innere Wandblatt mehrere, verteilt eingebrachte Durchbrüche aufweist, die wahlweise mit Abdeckplatten, in beiden Drehrichtungen betreibbare Ventilatoren und Schlauchabschnitten mit Anschlußplatten abdeckbar sind.

Je nach Abschluß der Durchbrüche kann mit den Ventilatoren an all diesen Stellen des inneren Wandplattes, die Durchbrüche aufweisen, Luft angesaugt oder eingeblasen werden. Dasselbe gilt für die Schlauchabschnitte, die dabei an ganz bestimmte, beliebig im Innenraum verteilte Komponenten herangeführt werden können. Mit den Abdeckplatten können nicht belegte Durchbrüche verschlossen werden. Die Bestückung des inneren Wandblattes als Teil des Wärmetauschers kann in vielfältiger Weise variiert und an die im Innenraum herrschenden Verhältnisse optimal angepaßt werden.

Nach einer bevorzugten Ausgestaltung sind die Durchbrüche im inneren Wandblatt rasterartig verteilt eingebracht. Dabei kann zudem vorgesehen sein, daß das innere Wandblatt aus mehreren, vertikal unterteilten Wandplatten zusammengesetzt ist.

Eine vorteilhafte Ausgestaltung sieht vor, daß die Durchbrüche quadratischen Querschnitt aufweisen.

Werden Ventilatoren verwendet, deren Eingangs- und Ausgangsbefestigungsebene im spitzen Winkel zueinander stehen, dann können an die quadratischen Durchbrüche die Ventilatoren in beliebig verdrehter Stellung angebracht und so die Ansaug- oder Einblasrichtung des Luftstromes in unterschiedliche Richtungen ausgerichtet werden. Die Ventilatoren können vorzugsweise als Saug- und Druckgebläse betrieben werden.

Sind die Schlauchabschnitte elastisch ausgebildet, dann können sie mit ihren offenen Enden leicht an Komponenten herangeführt werden, die an beliebigen Stellen im Innenraum des Schaltschrankes angeordnet sind. Die Komponenten können gezielt mit Kaltluft beaufschlagt werden. Es läßt sich aber auch die von den Kmponenten abgegebene Warmluft leicht gezielt absaugen.

Das doppelwandige Wandelement ist als Wärmetauscher ausgebildet, wobei der großflächige Luftkanal mit Warmluft gefüllt für ein großes Temperaturgefälle zur Außenluft sorgt. Damit wird über den Wärmetauscher ein guter Wirkungsgrad erzielt.

Das doppelwandige Wandelement kann eine Seitenwand oder die Rückwand des Schaltschrankes verschließen. Es kann jedoch auch als Schaltschranktür ausgebildet sein.

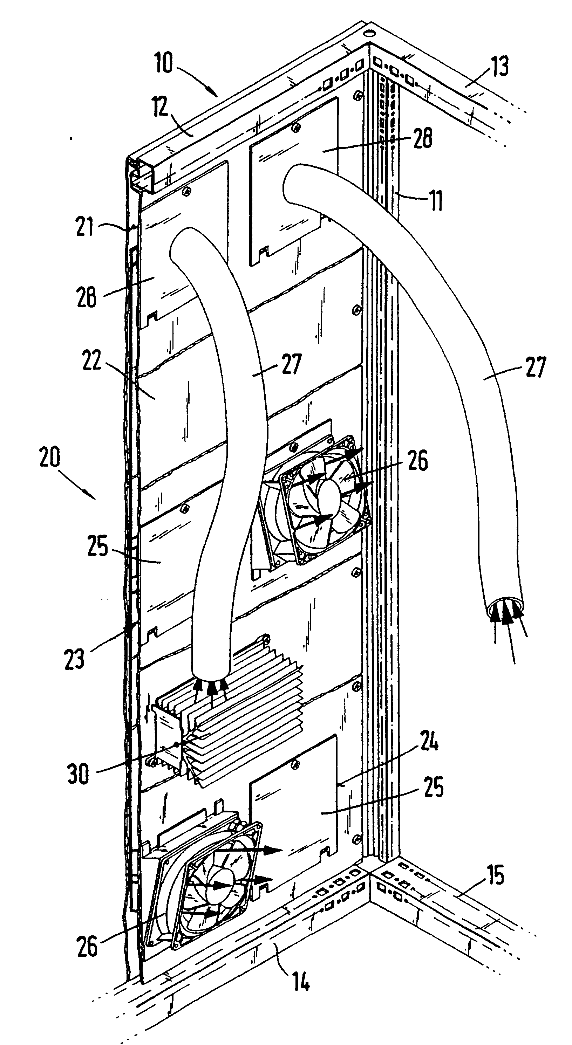

Die Erfindung wird anhand eines in der Zeichnung in perspektivischer Teildarstellung gezeigten Ausführungsbeispiels näher erläutert.

Bei dem Ausführungsbeispiel weist der Schaltschrank ein aus vertikalen und horizontalen Rahmenschenkeln 11, 12, 13, 14 und 15 zusammengesetzten Rahmengestell 10 auf, dessen Seiten mit Wandelementen und mindestens einer Schaltschranktür verschlossen oder verschließbar sind. Wie die Teilansicht zeigt, wird z.B. eine vertikale Seite des Rahmengestelles 10 mit einem doppelwandigen Wandelement 20 verschlossen, das aus einem äußeren Wandblatt 21 und einem inneren Wandblatt 22 besteht. Beide Wandblätter 21 und 22 bilden einen großflächigen Wärmetauscher mit einem entsprechend großflächigen Luftkanal 23 zwischen den Wandblättern 21 und 22.

Das innere Wandblatt 22 kann in vertikaler Richtung auch in mehrere Wandplatten unterteilt sein.

Über die gesamte Fläche des inneren Wandblattes 21 sind rasterförmig Durchbrüche 25 verteilt eingebracht, die wahlweise mittels Abdeckplatten 26, in beiden Drehrichtungen betreibbare Ventilatoren 26 oder Anschlußplatten 28 mit Schlauchabschnitten 27 abdeckbar sind. Die Belegung der Durchbrüche 25 mit diesen drei Anbauelementen kann beliebig gewählt und an die im Innenraum des Schaltschrankes auftretenden Verhältnisse und die Verteilung der Einbauten optimal angepaßt werden. So kann über einen Schlauchabschnitt 27 die von einem Kühlelement 30 aufgenommene Wärme direkt abgeführt werden, wenn der Schlauchabschnitt bis an diesen Kühlkörper 30 herangeführt wird.

Mit den Ventilatoren 26 kann an all den Stellen des inneren Wandblattes 22, an denen Durchbrüche 25 vorgesehen sind, Warmluft abgesaugt oder Kaltluft eingeblasen werden, wenn diese Ventilatoren 26 als Saug- und Druckgebläse betreibbar sind. Nicht belegte Durchbrüche 25 werden mittels Abdeckplatten 28 verschlossen, um definierte Strömungsverhältnisse im Innenraum des Schaltschrankes und über den Wärmetauscher zu erzielen.

Sind die Eingangs- und die Ausgangsbefestigungsebene des Ventilators 26 im spitzen Winkel zueinander angeordnet, dann kann der Ventilator 26 an dem quadratischen Durchbruch 25 in jeder beliebigen Drehstellung angebracht werden. Dadurch läßt sich die Ansaug- oder Einblasrichtung des Ventilators 26 in verschiedene Richtungen ausrichten, wie die beiden, in der Zeichnung dargestellten Ventilatoren 26 erkennen lassen.

Das doppelwandige Wandelement 20 als Wärmetauscher kann auch die Rückwand des Schaltschrankes bilden. Es kann aber auch als Schaltschranktür ausgebildet sein.

## Patentansprüche

1. Schaltschrank mit Einrichtungen zum Kühlen der im Innenraum desselben auftretenden Warmluft, bei dem mindestens eine Vertikalseite mit einem doppelwandigen Wandelement (20) abgeschlossen ist, dessen äußeres und inneres Wandblatt (21, 22) einen großflächigen Luftkanal (23) bilden, bei dem das innere Wandblatt (22) mehrere, verteilt eingebrachte Durchbrüche (25) aufweist, die wahlweise mit Abdeckplatten (25), in beiden Drehrichtungen betreibbare Ventilatoren (26) und Schlauchabschnitten (27) mit Anschlußplatte (28) abdeckbar sind.

2. Schaltschrank nach Anspruch 1,
**dadurch gekennzeichnet,**
**daß** die Durchbrüche (25) rasterartig über die gesamte Fläche des inneren Wandblattes (22) verteilt sind.

3. Schaltschrank nach Anspruch 1 oder 2,
**dadurch gekennzeichnet,**
**daß** das innere Wandblatt (22) aus mehreren, vertikal unterteilten Wandplatten zusammengesetzt ist.

4. Schaltschrank nach einem der Ansprüche 1 bis 3,
**dadurch gekennzeichnet,**
**daß** die Durchbrüche (25) quadratischen Querschnitt aufweisen.

5. Schaltschrank nach einem der Ansprüche 1 bis 4,
**dadurch gekennzeichnet,**
**daß** Ventilatoren (26) verwendet sind, deren Eingangs- und Ausgangsbefestigungsebene im spitzen Winkel zueinander stehen.

6. Schaltschrank nach einem der Ansprüche 1 bis 5,
**dadurch gekennzeichnet,**
**daß** die Ventilatoren (26) als Saug- oder Druckgebläse betreibbar sind.

7. Schaltschrank nach einem der Ansprüche 1 bis 6,
**dadurch gekennzeichnet,**
**daß** die Schlauchabschnitte (27) elastisch ausgebildet sind.

8. Schaltschrank nach einem der Ansprüche 1 bis 7,
**dadurch gekennzeichnet,**
**daß** das doppelwandige Wandelement (20) als Wärmetauscher ausgebildet ist.

9. Schaltschrank nach einem der Ansprüche 1 bis 8,
**dadurch gekennzeichnet,**
**daß** das doppelwandige Wandelement (20) als Seiten- oder Rückwand des Schaltschrankes ausgebildet ist.

10. Schaltschrank nach einem der Ansprüche 1 bis 8,
**dadurch gekennzeichnet,**
**daß** das doppelwandige Wandelement (20) als Schaltschranktür ausgebildet ist.

## Claims

1. Switchbox with devices for cooling the warm air occurring in its interior, in which at least one vertical side is closed off by means of a double-walled wall element (20), of which the outer and the inner wall leaf (21, 22) form a large-area air duct (23), and in which the inner wall leaf (22) has a plurality of perforations (25) which are introduced in a distributed manner and which can be covered selectively by cover plates (25), by fans (26) operable in both directions of rotation and by hose portions (27) with a connection plate (28).

2. Switchbox according to Claim 1, **characterized in that** the perforations (25) are distributed in a grid-like manner over the entire area of the inner wall leaf (22).

3. Switchbox according to Claim 1 or 2, **characterized in that** the inner wall leaf (22) is composed of a plurality of vertically subdivided wall plates.

4. Switchbox according to one of Claims 1 to 3, **characterized in that** the perforations (25) have a square cross section.

5. Switchbox according to one of Claims 1 to 4, **characterized in that** fans (26) are used, the entry and exit fastening planes of which are at an acute angle to one another.

6. Switchbox according to one of Claims 1 to 5, **characterized in that** the fans (26) can be operated as suction or delivery blowers.

7. Switchbox according to one of Claims 1 to 6, **characterized in that** the hose portions (27) are designed elastically.

8. Switchbox according to one of Claims 1 to 7, **characterized in that** the double-walled wall element (20) is designed as a heat exchanger.

9. Switchbox according to one of Claims 1 to 8, **characterized in that** the double-walled wall element (20) is designed as a side wall or rear wall of the switchbox.

10. Switchbox according to one of Claims 1 to 8, **characterized in that** the double-walled wall element (20) is designed as a switchbox door.

## Revendications

1. Armoire de distribution munie de dispositifs pour refroidir l'air chaud présent à l'intérieur de celle-ci, dans laquelle au moins un côté vertical est fermé avec un élément de paroi à double paroi (20), dont les panneaux de paroi extérieur et intérieur (21, 22) forment un canal d'air de grande surface (23), le panneau de paroi intérieur (22) présentant plusieurs interruptions (25) réparties, qui peuvent être recouvertes de manière sélective par des plaques de recouvrement (25), des ventilateurs (26) actionnables dans les deux directions et des portions de tuyau souple (27) avec une plaque de recouvrement (28).

2. Armoire de distribution selon la revendication 1, **caractérisée en ce que** les interruptions (25) sont réparties comme une trame sur toute la surface du panneau de paroi intérieur (22).

3. Armoire de distribution selon la revendication 1 ou 2, **caractérisée en ce que** le panneau de paroi intérieur (22) est constitué de plusieurs plaques de paroi divisées verticalement.

4. Armoire de distribution selon l'une quelconque des revendications 1 à 3, **caractérisée en ce que** les interruptions (25) présentent une section transversale carrée.

5. Armoire de distribution selon l'une quelconque des revendications 1 à 4, **caractérisée en ce que** l'on utilise des ventilateurs (26) dont les plans de fixation d'entrée et de sortie sont à angle aigu l'un par rapport à l'autre.

6. Armoire de distribution selon l'une quelconque des revendications 1 à 5, **caractérisée en ce que** les ventilateurs (26) peuvent être utilisés comme soufflantes d'aspiration ou de pression.

7. Armoire de distribution selon l'une quelconque des revendications 1 à 6, **caractérisée en ce que** les portions de tuyau souple (27) sont élastiques.

8. Armoire de distribution selon l'une quelconque des revendications 1 à 7, **caractérisée en ce que** l'élément de paroi à double paroi (20) est conçu en tant qu'échangeur de chaleur.

9. Armoire de distribution selon l'une quelconque des revendications 1 à 8, **caractérisée en ce que** l'élément de paroi à double paroi (20) est conçu en tant que paroi latérale ou de dos de l'armoire de distribution.

10. Armoire de distribution selon l'une quelconque des revendications 1 à 8, **caractérisée en ce que** l'élément de paroi à double paroi (20) est conçu en tant que porte d'armoire de distribution.
